# EUROPEAN PATENT APPLICATION

(11) **EP 4 726 783 A1**
(43) Date of publication of application: **15.04.2026**
(21) Application number: 24823300.9
(22) Date of filing: 06.06.2024
(51) Int. Cl.: H01L 31/0749

(54) **THIN FILM SOLAR CELL AND METHOD FOR MANUFACTURING THIN FILM SOLAR CELL**

(30) Priority: 12.06.2023 JP 2023096548
(71) Applicant: PXP Corporation, Sagamihara-shi, Kanagawa 252-0203 (JP); SOLABLE Inc., Tokyo 100-7014 (JP)
(72) Inventor: SUGIMOTO, Hiroki, Sagamihara-shi, Kanagawa 252-0203 (JP); HIRAI, Yoshiaki, Sagamihara-shi, Kanagawa 252-0203 (JP)
(74) Representative: EIP
(86) International application number: PCT/JP2024/020694
(87) International publication number: WO 2024/257684

(57) **Abstract**

Provided are a thin film solar cell capable of repairing damage caused by irradiation and a method for manufacturing a thin film solar cell. A p-type light absorbing layer of the thin film solar cell has a first region and a second region obtained by dividing the p-type light absorbing layer into two equal parts. The p-type light absorbing layer includes Cu as a group I element and includes Ga and In as a group III element, and an average value of a ratio C1 of the number of atoms of Cu to the number of atoms of the group III element in the first region is lower than an average value of the ratio C1 in the second region. An average value of the ratio G1 of the number of Ga atoms to the number of atoms of the group III element in the first region is lower than an average value of the ratio G1 in the second region, and an average value of the ratio G1 in the p-type light absorbing layer is 0.2 or more and 0.4 or less. An absolute value of a change rate of the ratio G1 when moving from a first electrode layer side to the second electrode layer side is maximized in the first region, and the ratio G1 in the p-type light absorbing layer tends to decrease from the first electrode layer side to the second electrode layer side in the first region.

## Description

### Technical Field

The present invention relates to a thin film solar cell and a method for manufacturing a thin film solar cell.

### Background Art

A thin film solar cell is present as one type of solar cell. In the thin film solar cell, there is a CIS-based thin film solar cell in which a group I-III-VI₂ compound having a chalcopyrite structure including Cu, In, Ga, Se, S, and the like is used as a p-type light absorbing layer. The CIS-based thin film solar cell is actively studied academically as described in Non-Patent Literature 1. In addition, an atomic profile of the p-type light absorbing layer for the object of improving a photoelectric conversion efficiency of the CIS-based thin film solar cell is described in Patent Literature 1. The thin film solar cell may be used in the outer space, and a thin film solar cell applied to the outer space is described in Non-Patent Literature 2.

### Citation List

### Patent Literature

Patent Literature 1: Japanese Patent No. 6297038

### Non-Patent Literatures

Non-Patent Literature 1: Physica Status Solidi. Rapid Research Letters, 2019, Vol.13, pp.1900415
Non-Patent Literature 2: Advanced Energy Materials, 2022, Vol.12, Issue 29, pp.2200125

### Summary of Invention

### Technical Problem

Strong the irradiation is present in the outer space, and a thin film solar cell disposed in the outer space is irradiated with strong the irradiation. The irradiation causes defects in a light absorbing layer in the thin film solar cell, which deteriorates the battery performance.

Therefore, an object of the present invention is to provide a thin film solar cell having a long life that is able to also withstand the irradiation and a method for manufacturing a thin film solar cell.

### Solution to Problem

A thin film solar cell according to one aspect of the present disclosure includes a substrate; a first electrode layer provided on the substrate; a p-type light absorbing layer provided on the first electrode layer and including a group I-III-VI₂ compound; and an n-type second electrode layer provided on the p-type light absorbing layer, in which the p-type light absorbing layer has a first region on a second electrode layer side and a second region other than the first region when the p-type light absorbing layer is divided into two equal parts in a depth direction of the p-type light absorbing layer. The p-type light absorbing layer includes Cu as a group I element, and includes Ga and In as a group III element, and an average value of a ratio of the number of Cu atoms to the number of atoms of the group III element in the first region is lower than an average value of a ratio of the number of Cu atoms to the number of atoms of the group III element in the second region. An average value of a ratio of the number of Ga atoms to the number of atoms of the group III element in the first region is lower than an average value of a ratio of the number of Ga atoms to the number of atoms of the group III element in the second region, and an average value of a ratio of the number of Ga atoms to the number of atoms of the group III element in the p-type light absorbing layer is 0.2 or more and 0.4 or less. An absolute value of a change rate in a ratio of the number of Ga atoms to the number of atoms of the group III element in the p-type light absorbing layer when moving from a first electrode layer side to the second electrode layer side is maximized in the first region, and the ratio of the number of Ga atoms to the number of atoms of the group III element in the p-type light absorbing layer tends to decrease from the first electrode layer side to the second electrode layer side in the first region.

A method for manufacturing a thin film solar cell according to one aspect of the present disclosure includes a first step of providing a first electrode layer on a substrate; a second step of providing a p-type light absorbing layer including a group I-III-VI₂ compound on the first electrode layer; and a third step of providing an n-type second electrode layer on the p-type light absorbing layer, in which the p-type light absorbing layer has a first region on a second electrode layer side and a second region other than the first region when the p-type light absorbing layer is divided into two equal parts in a depth direction of the p-type light absorbing layer, the p-type light absorbing layer includes Cu as a group I element, and includes Ga and In as a group III element, and in the second step, an average value of a ratio of the number of Cu atoms to the number of atoms of the group III element in the first region is lower than an average value of a ratio of the number of Cu atoms to the number of atoms of the group III element in the second region, an average value of a ratio of the number of Ga atoms to the number of atoms of the group III element in the first region is lower than an average value of a ratio of the number of Ga atoms to the number of atoms of the group III element in the second region, an average value of a ratio of the number of Ga atoms to the number of atoms of the group III element in the p-type light absorbing layer is 0.2 or more and 0.4 or less, an absolute value of a change rate in a ratio of the number of Ga atoms to the number of atoms of the group III element in the p-type light absorbing layer when moving from a first electrode layer side to the second electrode layer side is maximized in the first region, and the p-type light absorbing layer is provided and thus the ratio of the number of Ga atoms to the number of atoms of the group III element in the p-type light absorbing layer tends to decrease from the first electrode layer side to the second electrode layer side in the first region.

### Advantageous Effect of Invention

According to the present invention, it is possible to provide a thin film solar cell having a long life that is able to also withstand the irradiation and a method for manufacturing a thin film solar cell.

### Brief Description of Drawings

[Figure 1] Figure 1 is a cross-sectional view of a thin film solar cell according to the present embodiment.
[Figure 2] Figure 2 is a diagram illustrating a Cu profile in a p-type light absorbing layer according to the present embodiment.
[Figure 3] Figure 3 is a diagram illustrating a Ga profile in the p-type light absorbing layer according to the present embodiment.
[Figure 4] Figure 4 is a diagram illustrating another example of the Ga profile in the p-type light absorbing layer according to the present embodiment.
[Figure 5] Figure 5 is a diagram illustrating another example of the Ga profile in the p-type light absorbing layer according to the present embodiment.
[Figure 6A] Figure 6A is a cross-sectional view for describing an example of a method for manufacturing a thin film solar cell according to the present embodiment.
[Figure 6B] Figure 6B is a cross-sectional view for describing an example of the method for manufacturing a thin film solar cell according to the present embodiment.
[Figure 6C] Figure 6C is a cross-sectional view for describing an example of the method for manufacturing a thin film solar cell according to the present embodiment.
[Figure 6D] Figure 6D is a cross-sectional view for describing an example of the method for manufacturing a thin film solar cell according to the present embodiment.
[Figure 6E] Figure 6E is a cross-sectional view for describing an example of the method for manufacturing a thin film solar cell according to the present embodiment.
[Figure 7A] Figure 7A is a diagram describing a recovery effect of the thin film solar cell according to the present embodiment.
[Figure 7B] Figure 7B is a diagram describing the recovery effect of the thin film solar cell according to the present embodiment.
[Figure 7C] Figure 7C is a diagram describing the recovery effect of the thin film solar cell according to the present embodiment.
[Figure 7D] Figure 7D is a diagram describing the recovery effect of the thin film solar cell according to the present embodiment.
[Figure 8] Figure 8 is a diagram comparing recovery effects of the thin film solar cell according to the present embodiment and other thin film solar cells.

### Description of Embodiments

A preferred embodiment of the present invention will now be described with reference to the following drawings. In each drawing, elements provided with the same reference numerals have the same or similar configurations.

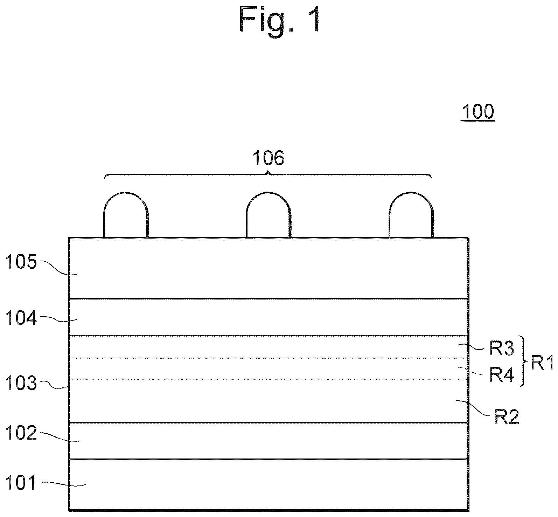

Figure 1 illustrates a cross-sectional view of a thin film solar cell 100 according to the present embodiment. The thin film solar cell 100 has a substrate 101, a first electrode layer 102, a p-type light absorbing layer 103, an electron transport layer 104, a second electrode layer 105, and a grid electrode 106. The thin film solar cell 100 generates power by receiving light from a grid electrode 106 side.

As the substrate 101, for example, a glass substrate such as blue plate glass or low alkali glass, a metal substrate such as a stainless steel plate, a polyimide resin substrate, or the like is able to be used. The first electrode layer 102 is able to be disposed on, for example, on the substrate 101 and a metal conductive layer formed of a metal material such as Mo, Cr, or Ti is used. A film thickness of the first electrode layer 102 is able to be, for example, 200 to 800 nm.

The p-type light absorbing layer 103 is disposed on, for example, the first electrode layer 102 and is formed of a group I-III-VI₂ compound. The p-type light absorbing layer 103 includes Cu as a group I element, includes Ga and In as a group III element, and includes Se and S as a group VI element. A film thickness of the p-type light absorbing layer 103 is able to be, for example, 1 to 3 µm.

The p-type light absorbing layer 103 has a first region R1 on a second electrode layer 105 side and a second region R2 on a first electrode layer 102 side, which is different from the first region when the p-type light absorbing layer 103 is divided into two equal parts, with respect to a depth direction of the p-type light absorbing layer 103. In addition, the first region R1 has a third region R3 on the second electrode layer 105 side and a fourth region R4 on the second region R2 or the first electrode layer 102 side, which is different from the third region when the first region R1 is divided into two equal parts, with respect to the depth direction of the p-type light absorbing layer 103.

The electron transport layer 104 is able to be disposed on, for example, the p-type light absorbing layer 103 and Zn(O, S, OH)ₓ which has n-type conductivity, is transparent, and has high resistance is able to be used. The electron transport layer 104 is able to be formed into a film, for example, with a film thickness of 20 to 150 nm. In addition, the electron transport layer 104 is able to also be formed of, for example, a group II-VI compound semiconductor thin film such as CdS, ZnS, and ZnO, Zn(O, S)ₓ which is a mixed crystal thereof, and the like, and specific examples thereof include In-based compound semiconductor thin films such as In₂O₃, In₂S₃, and In(O, S, OH)ₓ.

The second electrode layer 105 is disposed on, for example, the electron transport layer 104, and ZnO:B which has an n-type conductivity and is transparent, of which a forbidden band width is wide, and a resistance value is low is able to be used. The second electrode layer 105 is able to be formed into a film, for example, as a transparent conductive film having a thickness of 0.1 to 1.5 µm. In addition, the second electrode layer 105 is able to also be formed of a transparent conductive film formed of ZnO:Al, ZnO:Ga, and ITO.

The grid electrode 106 is, for example, an electrode disposed on the second electrode layer 105 and is provided to take out electricity from the second electrode layer 105. The grid electrode 106 is a conductive material, and for example, a metal material, an alloy material, a transparent conductive material, or the like is able to be used.

### <Examples>

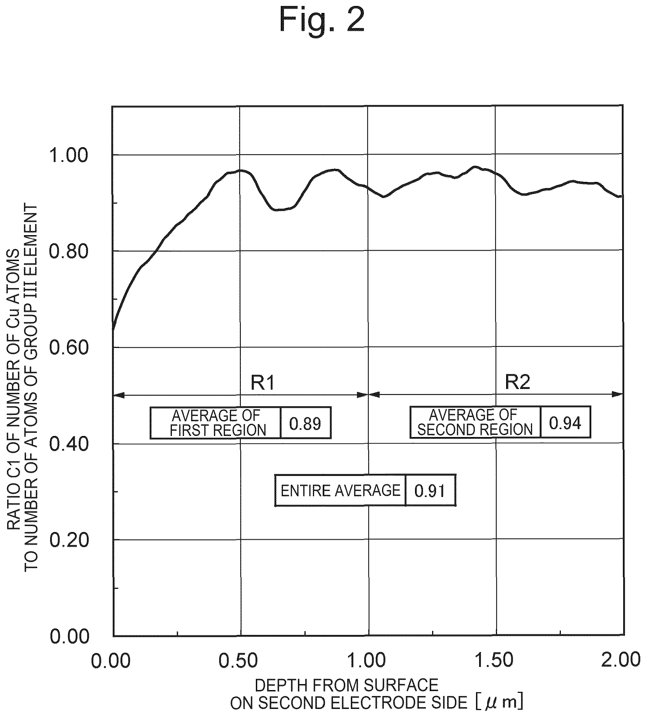

Next, a ratio (C1) of the number of Cu atoms to the number of atoms of the group III element a and the ratio (G1) of the number of Ga atoms to the number of atoms of the group III element in the p-type light absorbing layer 103 of the thin film solar cell 100 according to the present embodiment will be described. The inventors manufacture three (A to C) thin film solar cells 100 according to the present embodiment, and describe the ratios C1 and G1 measured for three examples with reference to Figures 2 to 5. The number of atoms is measured, for example, by measuring a cross section of the light absorbing layer by an energy dispersive X-ray spectroscopy using a scanning type electron microscope.

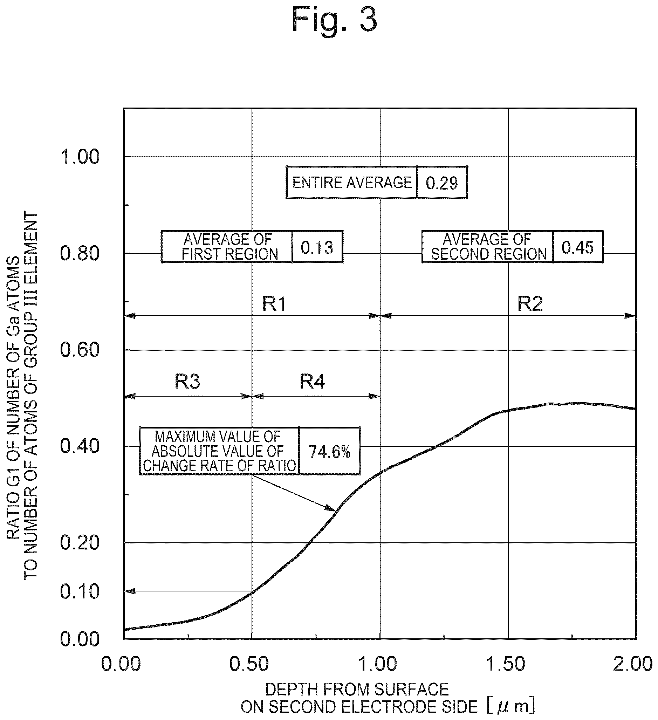

Figure 2 illustrates an example of the ratio C1 of the number of Cu atoms to the number of atoms of the group III element in the p-type light absorbing layer 103 of Example A of the thin film solar cell 100. A horizontal axis of Figure 2 represents a depth from a surface of the p-type light absorbing layer 103 on the second electrode layer 105 side. The horizontal axis is also common in Figures 3 to 5. The ratio C1 of the number of Cu atoms to the number of atoms of the group III element is calculated as a ratio of (the number of Cu atoms)/(the number of atoms of the group III element). The group III element is, for example, In or Ga.

The ratio C1 of the entire layer of the p-type light absorbing layer 103 is less than 1.0. In the example of Figure 2, an average value of the ratio C1 in the entire layer is 0.91. When the ratio C1 is 1.0 or more, there is a possibility that a photoelectric conversion efficiency is lowered. On the other hand, it is preferable that the ratio C1 is more than 0.80 from the viewpoint of forming the p-type light absorbing layer having an appropriate carrier concentration.

In addition, in the p-type light absorbing layer 103, the average value of the ratio C1 in the first region R1 is lower than the average value of the ratio C1 in the second region R2. In the example of Figure 2, the average value of the ratio C1 in the first region R1 is 0.89, and the average value of the ratio C1 in the second region R2 is 0.94.

As described above, by lowering the ratio C1 on the surface on the second electrode layer 105 side, the thin film solar cell 100 is able to repair damage caused by the irradiation.

Specifically, it is known that the irradiation causes a defect in Cu in a crystal structure of the p-type light absorbing layer 103. As the defect, there is an anti-site defect occurred by disposing In or Ga, which is the group III element, in a Cu vacancy generated by the irradiation. The anti-site defect greatly deteriorates electrical characteristics. The anti-site defect is passivated (passivation) by being modified by other Cu vacancies, and in this case, the deterioration of the electrical characteristics is reduced. In addition, it is known that Cu vacancies are able to also transit within the p-type light absorbing layer even with relatively weak external energy such as light irradiation or heating, and by using this transition to promote the modification of the anti-site defect due to the Cu vacancies, self-repair is able to be performed even when the thin film solar cell 100 is damaged, and as a result, the damage due to the irradiation is able to be repaired.

In the p-type light absorbing layer 103, by reducing the ratio of the number of Cu atoms to the number of atoms of the group III element on the surface on the second electrode layer 105 side, it is possible to increase the number of Cu vacancies that bring about defect repair, and thus it is possible to sufficiently perform self-repair, and the thin film solar cell 100 is able to repair damage caused by the irradiation.

Figures 3 to 5 illustrate an example of a ratio G1 of the number of Ga atoms to the number of atoms of the group III element in the p-type light absorbing layer 103 in Examples A to C. The ratio G1 of the number of Ga atoms to the number of atoms of the group III element is calculated as a ratio of (the number of Ga atoms)/(the number of atoms of the group III element).

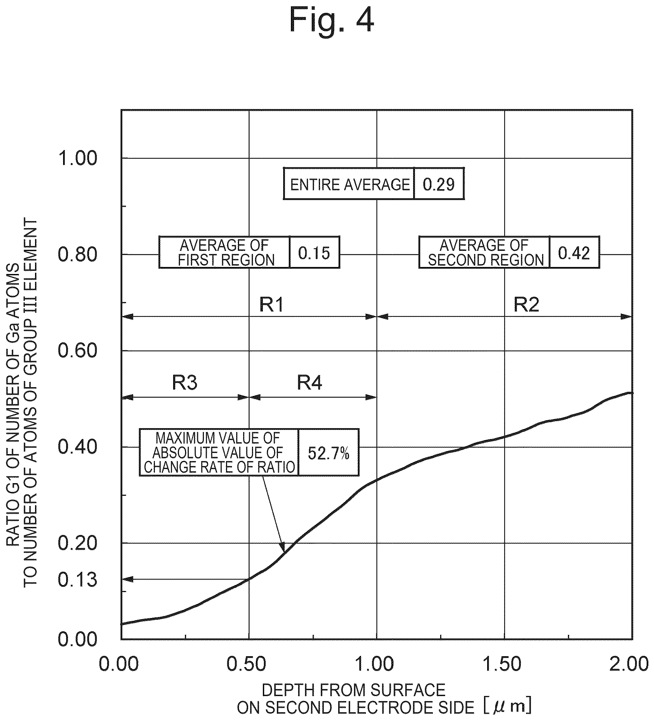

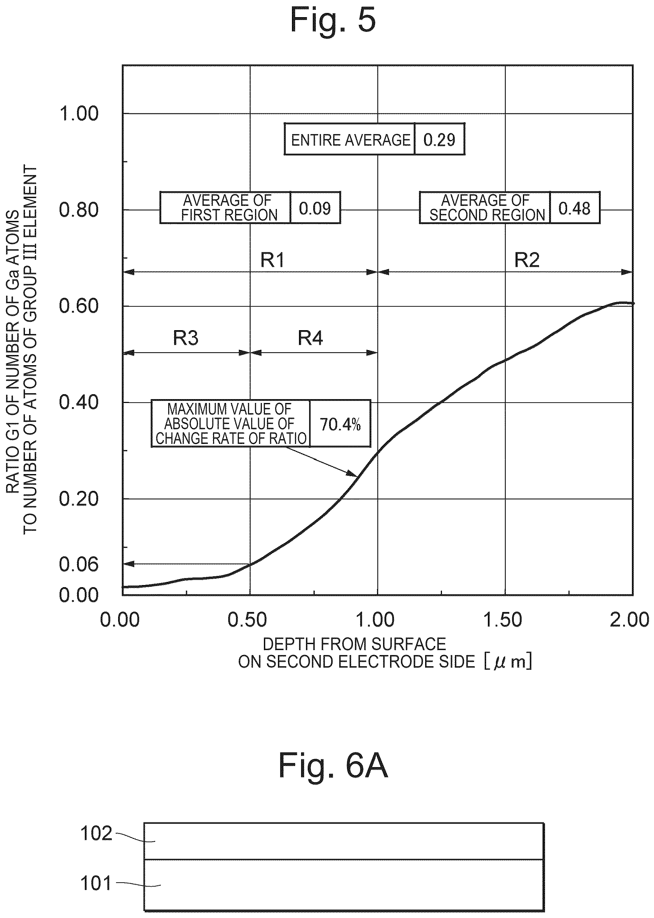

In the p-type light absorbing layer 103, an average value of the ratio G1 in the first region R1 is lower than the average value of the ratio G1 in the second region R2. In the example of Figure 3, the average value of the ratio G1 in the first region R1 in Example A is 0.13, and the average value of the ratio G1 in the second region is 0.45. In the example of Figure 4, the average value of the ratio G1 in the first region R1 in Example B is 0.15, and the average value of the ratio G1 in the second region is 0.42. In the example of Figure 5, the average value of the ratio G1 in the first region R1 in Example C is 0.09, and the average value of the ratio G1 in the second region is 0.48.

In the p-type light absorbing layer 103, the average value of the ratio G1 in the p-type light absorbing layer 103 is 0.2 or more and 0.4 or less. In Figures 3, 4, and 5, a case where the average value of the ratio G1 in the entire p-type light absorbing layer 103 is 0.29 is illustrated. By setting the average value of the ratio G1 to 0.2 or more and 0.4 or less, the photoelectric conversion efficiency is able to be increased.

In the p-type light absorbing layer 103, an absolute value of a change rate of the ratio G1 when moving from the first electrode layer 102 side to the second electrode layer 105 side is maximized in the first region R1. In the example of Figure 3, the absolute value of the change rate of the ratio G1 reaches a maximum value of 74.6% in the first region R1. In the example of Figure 4, the absolute value of the change rate of the ratio G1 reaches a maximum value of 52.7% in the first region R1. In the example of Figure 5, the absolute value of the change rate of the ratio G1 reaches a maximum value of 70.4% in the first region R1. More specifically, the absolute value of the change rate of the ratio G1 is maximized in the fourth region R4 in the first region R1 in all of Figures 3 to 5.

In this way, by setting a position where the absolute value of the change rate of the ratio G1 is maximized to be in the first region R1 which is the region on the second electrode layer 105 side, it is possible to promote electron movement to the surface on the second electrode layer 105 side, which uses a band tilt of a conduction band of the p-type light absorbing layer 103.

The ratio G1 in the p-type light absorbing layer 103 tends to decrease from the first electrode layer 102 side to the second electrode layer 105 side in the first region R1. This tendency is commonly illustrated in each of Figures 3, 4, and 5.

In the p-type light absorbing layer 103, the ratio G1 in the third region R3 is preferably 0.15 or less. More preferably, the ratio G1 is, for example, 0.13 or less. In the example of Figure 3, the maximum value of the ratio G1 in the third region R3 is 0.10. In the example of Figure 4, the maximum value of the ratio G1 in the third region R3 is 0.13. In the example of Figure 5, the maximum value of the ratio G1 in the third region R3 is 0.06. In addition, in a region of the first region R1 having a depth of 300 nm from the surface on the second electrode layer 105 side, the ratio G1 is 0.1 or less.

As described above, by adjusting the ratio G1 in the entire p-type light absorbing layer 103 and the ratio G1 on the surface on the second electrode layer 105 side, the thin film solar cell 100 is able to repair damage caused by the irradiation. Among the above-described anti-site defects, the anti-site defect in which Ga is disposed in the Cu vacancy has a characteristic that self-repair is not easily performed by light irradiation or heating. As in the p-type light absorbing layer 103, by reducing the ratio of the number of Ga atoms to the number of atoms of the group III elements on the surface on the second electrode layer 105 side, Ga that causes occurrence of defect difficult to self-repair is able to be reduced, and thus the occurrence of defects is able to be suppressed, and the thin film solar cell 100 is able to repair damage caused by the irradiation.

Finally, the p-type light absorbing layer 103 includes S as a group VI element. More specifically, S may be included in the first region R1. Accordingly, the band gap of the p-type light absorbing layer 103 is able to be adjusted, and the photoelectric conversion efficiency is able to be increased. In particular, S is included in the first region R1 in which the ratio of Ga is reduced, and thus it is possible to increase the photoelectric conversion efficiency while being able to repair damage caused by the irradiation.

### <Manufacturing method>

Next, a manufacturing method for the thin film solar cell 100 will be described with reference to Figures 6A to 6E.

First, as illustrated in Figure 6A, the first electrode layer 102 is formed on the substrate 101. A thickness of the first electrode layer 102 may be, for example, 200 to 800 nm. The first electrode layer 102 is formed, for example, by a DC sputtering method using Mo as a material. As film forming conditions of the DC sputtering method, a film forming pressure may be 0.5 to 2.5 Pa, and applied power may be 1.0 to 3.0 W/cm².

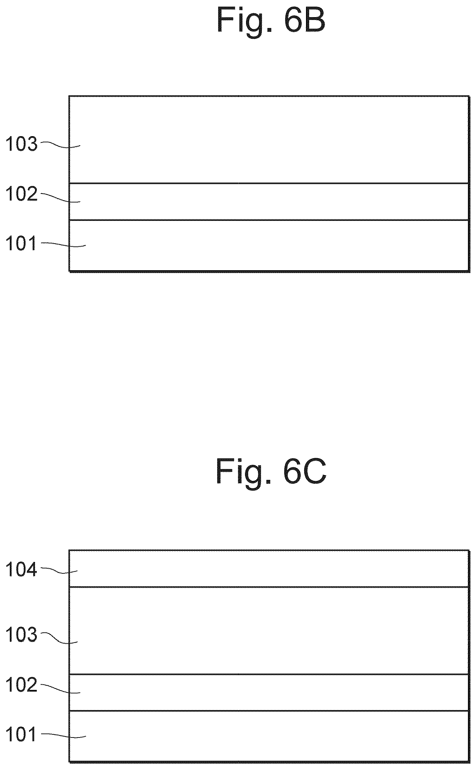

Next, as illustrated in Figure 6B, the p-type light absorbing layer 103 including the group I-III-VI₂ compound is formed on the first electrode layer 102.

Examples of a method for forming the p-type light absorbing layer 13 include (1) a method for forming a metal precursor film of the group I element and the group III element and forming a compound of the metal precursor film and the group VI element, and (2) a method for forming into a film of the group I element, the group III element, and the group VI element using a vapor deposition method.

First, a case where the p-type light absorbing layer 103 is formed using the method (1) will be described. In the method (1), a precursor film including Ga and Cu is formed on the first electrode layer 102, then a precursor film including In is formed, and then the compound of a precursor film including Ga and Cu, the precursor film including In, and the group VI element (Se and S) is formed. As described above, a precursor film including a mixed crystal of Ga and Cu may be formed for Cu which is the group I element, or a precursor film including Cu may be laminated on the precursor film including Ga. A Cu concentration on the surface of the precursor film is controlled by using an Se-S concentration in a reaction gas.

Each precursor film is able to be formed using, for example, a well-known film forming technique such as a sputtering method. In this manner, the p-type light absorbing layer 103 having an atomic profile described with reference to Figures 2 to 5 is able to be formed.

In addition, the ratio G1 of the number of Ga atoms to the number of atoms of the group III element on the surface is able to also be reduced by shortening a heat treatment time for forming the compound with the group VI element or by adding an alkali compound (for example, adding to the precursor film or diffusing from the substrate).

The ratio C1 of the number of Cu atoms to the number of atoms of the group III element in the entire p-type light absorbing layer 103 is able to be adjusted by controlling the number of Cu atoms and the number of atoms of the group III element in the precursor film to be laminated, for example, by changing the ratio of the film thickness of the Cu-Ga precursor film to the film thickness of the In precursor film or the ratio of the film thickness of the Cu-Ga precursor film to the film thickness of the Cu precursor film.

Next, a case of forming the p-type light absorbing layer 103 by the method (2) will be described. In the method (2), in a case of vapor deposition using the group I element, the group III element, and the group VI element as vapor deposition sources on the first electrode layer 102, a semiconductor layer having a chalcopyrite structure is formed by vapor-depositing Ga before vapor deposition of In as the group III element, and the p-type light absorbing layer 103 is formed. In this manner, the p-type light absorbing layer 103 having the atomic profile described with reference to Figures 2 to 5 may be formed. In addition, the ratio G1 of the number of Ga atoms to the number of atoms of the group III element on the surface is able to also be reduced by shortening the heat treatment time for vapor-depositing the group VI element or by adding an alkali compound (vapor deposition using the alkali compound as the vapor deposition source or diffusion of an alkali metal from the substrate).

Cu, which is the group I element, may be further vapor-deposited as a vapor deposition film including Cu and Ga or In, or as a vapor deposition source including Cu and S or Se, to form the p-type light absorbing layer.

Se or S, which is the group VI element, may be vapor-deposited as a Se film, an S film, or a film including Se and S.

For example, the p-type light absorbing layer 103 is formed by first vapor-depositing Ga and Se, or vapor-depositing Ga, In, and Se, then vapor-depositing Cu, Se, and S, and finally vapor-depositing In, Se, and S on the first electrode layer 102. A compound of Cu, Se or S, In, and Ga is formed by heat when each element is vapor-deposited. In addition, after each element is vapor-deposited, heat treatment for forming the compound of Cu, Se or S, In, and Ga may be performed. For the vapor deposition, for example, a method such as a multi-target simultaneous vapor deposition method is able to be used.

In addition, the p-type light absorbing layer 103 may be formed by first vapor-depositing Cu and Ga (or a CuGa compound), then vapor-depositing Cu and In (or a Culn compound), and then vapor-depositing Se, S, and In (or an InSeS compound) on the first electrode layer 102. A compound of Cu, Se or S, In, and Ga is formed by heat when In (Se and S) is vapor-deposited. In addition, after In (Se and S) is vapor-deposited, heat treatment for forming the compound of Cu, Se or S, In, and Ga may be performed.

In addition, the p-type light absorbing layer 103 may be formed by first vapor-depositing Cu and Ga (or a CuGa compound), then vapor-depositing Cu and In (or a Culn compound), and then vapor-depositing Se and S (or a SeS compound) on the first electrode layer 102. A compound of Cu, Se or S, In, and Ga is formed by heat when Se-S is vapor-deposited. In addition, after the Se-S is vapor-deposited, heat treatment for forming a compound of Cu, Se or S, In, and Ga may be performed. The above is the description of the step of forming the p-type light absorbing layer 103 using the method (2).

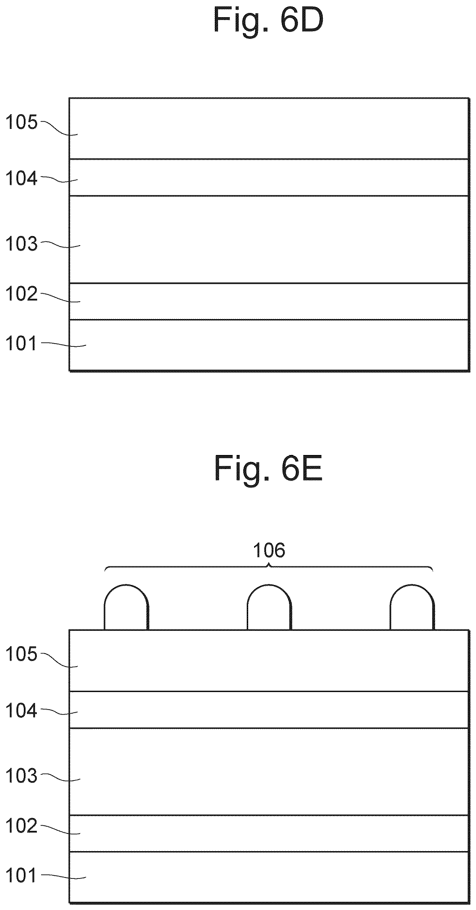

Next, as illustrated in Figure 6C, the electron transport layer 104 is formed on the p-type light absorbing layer 103. The electron transport layer 104 is able to be formed by a solution growth method, an MOCVD method, an ALD method, a vapor deposition method, or a sputtering method. Next, as illustrated in Figure 6D, the second electrode layer 105 is formed on the electron transport layer 104. The second electrode layer 105 may be formed by the sputtering method or the MOCVD method. Next, as illustrated in Figure 6E, the grid electrode 106 is formed on the second electrode layer 105. The grid electrode 106 may be formed, for example, by the vapor deposition method or by printing a paste-like conductive material on the second electrode layer 105.

### <Self-repairing effect>

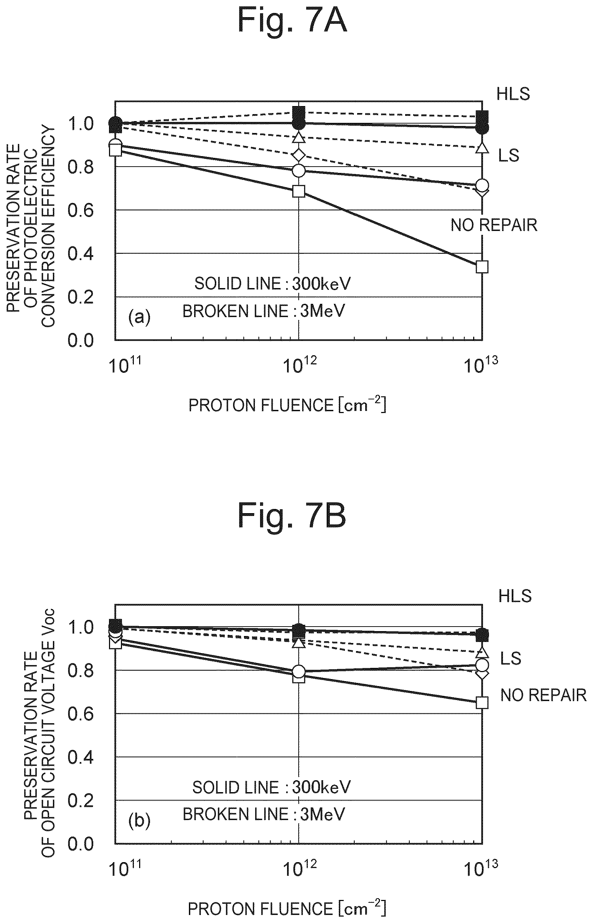

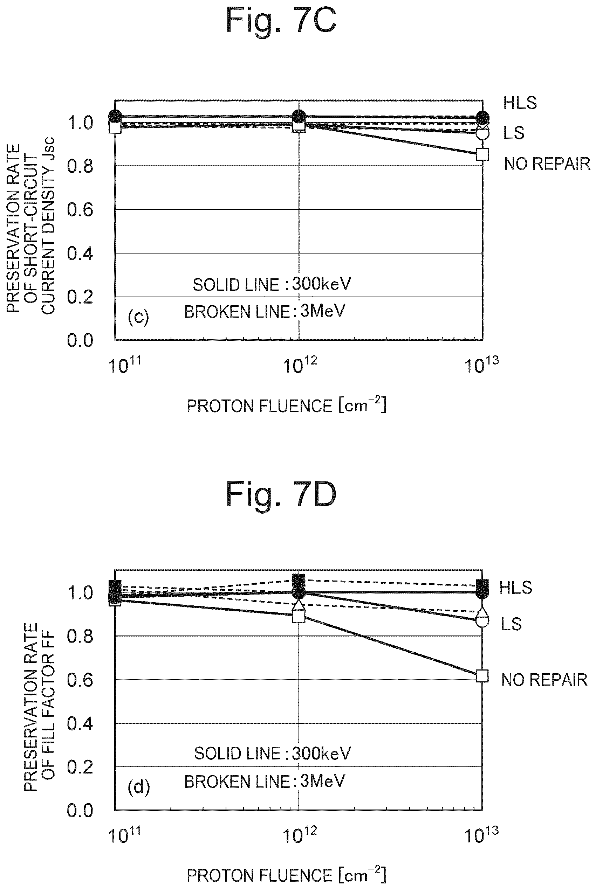

A self-repairing effect of the thin film solar cell 100 will be described with reference to Figures 7A to 7D. Figures 7A to 7D illustrate a preservation rate of the photoelectric conversion efficiency of the thin film solar cell 100 (Figure 7A), a preservation rate of an open circuit voltage V_{oc} of the thin film solar cell 100 (Figure 7B), a preservation rate of a short-circuit current density J_{sc} of the thin film solar cell 100 (Figure 7C), and a preservation rate of a fill factor FF of the thin film solar cell 100 (Figure 7D), respectively, when the thin film solar cell 100 is irradiated with a proton beam. Each data of Figures 7A to 7D is an average value of data of a plurality of thin film solar cells 100 including the thin film solar cells 100 of Examples A, B, and C.

The horizontal axis of Figures 7A to 7D is proton fluence indicating the number of particles of the proton beam per unit area. In Figures 7A to 7D, a solid line indicates each preservation rate when the proton beam of 300 keV is irradiated, and a broken line indicates each preservation rate when the proton beam of 3 MeV is irradiated. The preservation rate is a ratio of a value after the irradiation to a value before the irradiation. In addition, in the examples of Figures 7A to 7D, each preservation rate when light irradiation (Light Soaking: LS) and heat light irradiation (Heat Light Soaking: HLS) are performed for the self-repair of the thin film solar cell 100 after the irradiation is illustrated. The movement of the Cu defect in the p-type light absorbing layer 103 is promoted by the light irradiation or the heat light irradiation, the anti-site defect is modified, and the performance of the thin film solar cell 100 is recovered. In addition, each preservation rate when the light irradiation or the heat light irradiation is not performed is illustrated for comparison.

As commonly illustrated in Figures 7A to 7D, in the thin film solar cell 100, even when the performance is degraded, for example, as illustrated when no repair is performed, the respective characteristics are largely recovered by the light irradiation or the heat light irradiation by the irradiation of the proton beam. It is considered that the recovery of such characteristics is due to the fact that the p-type light absorbing layer 103 has the atomic profile described with reference to Figures 2 to 5.

In the examples of Figures 7A to 7D, the heat irradiation was performed by irradiating the cell with light at a temperature of 150°C for 1 hour. This corresponds to about 16 to 69 days at a temperature of 60°C. Therefore, the thin film solar cell 100 may perform sufficient self-repair even in an actual space environment.

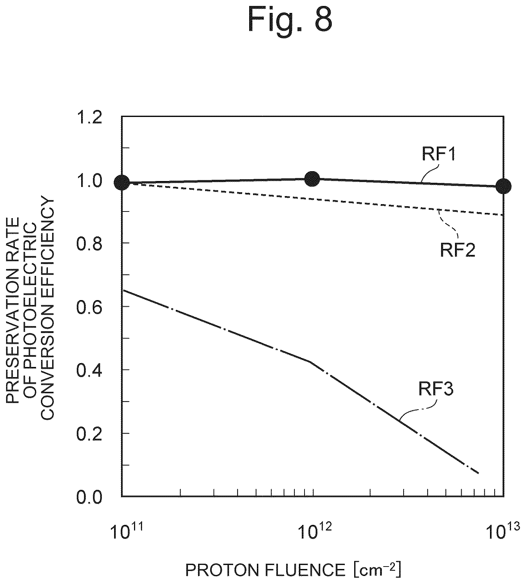

Figure 8 illustrates the preservation rate of the photoelectric conversion efficiency when each of the thin film solar cell 100 according to the present embodiment and another thin film solar cell is irradiated with the proton beam of 300 keV and self-repair by heat irradiation is performed. The data of the thin film solar cell 100 in Figure 8 is an average value of data of a plurality of thin film solar cells 100 including the thin film solar cells 100 of Examples A, B, and C. Figure 8 illustrates a preservation rate RF1 of the photoelectric conversion efficiency of the thin film solar cell 100, a preservation rate RF2 of the photoelectric conversion efficiency of the thin film solar cell described in Non-Patent Literature 1, and a preservation rate RF3 of the photoelectric conversion efficiency of the thin film solar cell (GaAs-based) described in Non-Patent Literature 2. It is illustrated that the thin film solar cell 100 has a high self-repairing effect as compared with other thin film solar cells.

In a general thin film solar cell disposed in the outer space, in order to suppress the deterioration of the battery performance, for example, protective means such as cover glass that protects the light absorbing layer of the thin film solar cell is attached to the thin film solar cell with an adhesive. However, the cover glass and the adhesive for space are very expensive, and the use of the cover glass and the adhesive increases the weight of the entire power generation device, which is not preferable. Therefore, as in the thin film solar cell 100, the thin film solar cell itself is able to sufficiently perform the self-repair, and thus it is not necessary to use cover glass or the adhesive. Accordingly, the battery module including the thin film solar cell 100 is able to be made lightweight, and the cost for launching and the cost depending on the number of components is able to be reduced. Furthermore, since the thin film solar cell 100 is able to self-repair damage caused by the irradiation, the thin film solar cell 100 is able to be used as a long life battery in the outer space or an atmosphere of a stratosphere or higher. In addition, since the thin film solar cell 100 has the irradiation resistance, the thin film solar cell 100 is able to be used as a battery having a longer life than the conventional thin film solar cell even under an irradiation environment. In addition, the thin film solar cell 100 is able to also be used as a battery having a longer life even in the convection zone where the irradiation dose is lower than that in the outer space. For example, the thin film solar cell 100 is able to be used as a power generation device having a long life by being attached to a surface (roof, window, wall surface, or the like) of a building, a moving object, a flying object, or the like.

The thin film solar cell 100 according to the present embodiment is described above. The thin film solar cell 100 includes the substrate 101, the first electrode layer 102 provided on the substrate 101, the p-type light absorbing layer 103 provided on the first electrode layer 102 and including the group I-III-VI₂ compound, and the n-type second electrode layer 105 provided on the p-type light absorbing layer 103, in which the p-type light absorbing layer 103 has the first region R1 on the second electrode layer 105 side and the second region R2 other than the first region R1 when the p-type light absorbing layer 103 is divided into two equal parts in the depth direction of the p-type light absorbing layer 103. The p-type light absorbing layer 103 includes Cu as the group I element and includes Ga and In as the group III element, and the average value of the ratio of the number of Cu atoms to the number of atoms of the group III element in the first region R1 is lower than the average value of the ratio of the number of Cu atoms to the number of atoms of the group III element in the second region R2. The average value of the ratio of the number of Ga atoms to the number of atoms of the group III element in the first region R1 is lower than the average value of the ratio of the number of Ga atoms to the number of atoms of the group III element in the second region R2, and the average value of the ratio of the number of Ga atoms to the number of atoms of the group III element in the p-type light absorbing layer 103 is 0.2 or more and 0.4 or less. In the p-type light absorbing layer 103, the absolute value of the change rate in the ratio of the number of Ga atoms and the number of atoms of the group III element when moving from the first electrode layer 102 side to the second electrode layer 105 side is maximized in the first region R1, and the ratio of the number of Ga atoms and the number of atoms of the group III element in the p-type light absorbing layer tends to decrease from the first electrode layer 102 side to the second electrode layer 105 side in the first region R1.

In the p-type light absorbing layer 103, the amount of Cu vacancies that bring about the repair of the defects occurred by the irradiation is able to be increased on the second electrode layer 105 side, and thus the thin film solar cell 100 is able to repair the damage caused by the irradiation. In addition, by reducing the ratio of the number of Ga atoms to the number of atoms of the group III element on the surface on the second electrode layer 105 side, Ga, which causes occurrence of defect that makes self-repair difficult, is able to be reduced, and thus the occurrence of defects is able to be suppressed, and the thin film solar cell 100 is able to easily repair damage caused by the irradiation. By setting the position where the absolute value of the change rate of the ratio of the number of Ga atoms to the number of atoms of the group III element is maximized in the first region R1, the electron movement to the surface on the second electrode layer 105 side, which uses the band tilt of the conduction band of the p-type light absorbing layer 103, is able to be promoted, and the electrical characteristics are able to be improved. Due to these factors, the thin film solar cell 100 is able to repair damage caused by the irradiation.

In addition, the p-type light absorbing layer 103 may include S as the group VI element, and thus the band gap of the p-type light absorbing layer 103 is able to be adjusted, and the photoelectric conversion efficiency is able to be increased. In particular, when the first region R1 in which the ratio of Ga is reduced includes S, it is possible to increase the photoelectric conversion efficiency while being capable of repairing damage caused by the irradiation.

The embodiments described above are for facilitating the understanding of the present invention, and are not for limiting the interpretation of the present invention. Each element included in the embodiments and the disposition, material, condition, shape, size thereof, and the like are not limited to those exemplified and are able to be appropriately changed. In addition, the configurations described in the different embodiments are able to be partially replaced or combined with each other.

### Reference Signs List

100: thin film solar cell
101: substrate
102: first electrode layer
103: p-type light absorbing layer
104: electron transport layer
105: second electrode layer
106: grid electrode

## Claims

1. A thin film solar cell comprising:
a substrate;
a first electrode layer provided on the substrate;
a p-type light absorbing layer provided on the first electrode layer and including a group I-III-VI₂ compound; and
an n-type second electrode layer provided on the p-type light absorbing layer,
wherein the p-type light absorbing layer has a first region on a second electrode layer side and a second region other than the first region when the p-type light absorbing layer is divided into two equal parts in a depth direction of the p-type light absorbing layer,
the p-type light absorbing layer
contains Cu as a group I element, and
contains Ga and In as a group III element,
an average value of a ratio of the number of Cu atoms to the number of atoms of the group III element in the first region is lower than an average value of a ratio of the number of Cu atoms to the number of atoms of the group III element in the second region,
an average value of a ratio of the number of Ga atoms to the number of atoms of the group III element in the first region is lower than an average value of a ratio of the number of Ga atoms to the number of atoms of the group III element in the second region,
an average value of a ratio of the number of Ga atoms to the number of atoms of the group III element in the p-type light absorbing layer is 0.2 or more and 0.4 or less,
an absolute value of a change rate in a ratio of the number of Ga atoms to the number of atoms of the group III element in the p-type light absorbing layer when moving from a first electrode layer side to the second electrode layer side is maximized in the first region, and
the ratio of the number of Ga atoms to the number of atoms of the group III element in the p-type light absorbing layer tends to decrease from the first electrode layer side to the second electrode layer side in the first region.

2. The thin film solar cell according to Claim 1,
wherein the first region has a third region on the second electrode layer side and a fourth region other than the third region when the first region is divided into two equal parts in the depth direction, and
a ratio of the number of Ga atoms to the number of atoms of the group III element in the third region is 0.15 or less.

3. The thin film solar cell according to Claim 2,
wherein the absolute value of the change rate is maximized in the fourth region.

4. The thin film solar cell according to Claim 1,
wherein the p-type light absorbing layer includes S as a group VI element.

5. The thin film solar cell according to Claim 4,
wherein S is included in the first region.

6. A method for manufacturing a thin film solar cell, comprising:
a first step of providing a first electrode layer on a substrate;
a second step of providing a p-type light absorbing layer including a group I-III-VI₂ compound on the first electrode layer; and
a third step of providing an n-type second electrode layer on the p-type light absorbing layer,
wherein the p-type light absorbing layer has a first region on a second electrode layer side and a second region other than the first region when the p-type light absorbing layer is divided into two equal parts in a depth direction of the p-type light absorbing layer,
the p-type light absorbing layer
contains Cu as a group I element, and
contains Ga and In as a group III element, and
in the second step,
an average value of a ratio of the number of Cu atoms to the number of atoms of the group III element in the first region is lower than an average value of a ratio of the number of Cu atoms to the number of atoms of the group III element in the second region,
an average value of a ratio of the number of Ga atoms to the number of atoms of the group III element in the first region is lower than an average value of a ratio of the number of Ga atoms to the number of atoms of the group III element in the second region,
an average value of a ratio of the number of Ga atoms to the number of atoms of the group III element in the p-type light absorbing layer is 0.2 or more and 0.4 or less,
an absolute value of a change rate in a ratio of the number of Ga atoms to the number of atoms of the group III element in the p-type light absorbing layer when moving from a first electrode layer side to the second electrode layer side is maximized in the first region, and
the p-type light absorbing layer is provided and thus the ratio of the number of Ga atoms to the number of atoms of the group III element in the p-type light absorbing layer tends to decrease from the first electrode layer side to the second electrode layer side in the first region.
